Europäisches Patentamt

European Patent Office

Office européen des brevets

(19)

(11) Publication number: **0 184 250 B1**

(12) # EUROPEAN PATENT SPECIFICATION

(45) Date of publication of patent specification: **02.09.92**  (51) Int. Cl.⁵: **H01S 3/18**, H01S 3/0959

(21) Application number: **85201896.9**

(22) Date of filing: **19.11.85**

(54) Electron-beam-pumped semiconductor laser and array.

(30) Priority: **04.12.84 US 677943**

(43) Date of publication of application:
**11.06.86 Bulletin 86/24**

(45) Publication of the grant of the patent:
**02.09.92 Bulletin 92/36**

(84) Designated Contracting States:
**DE FR GB IT NL**

(56) References cited:
EP-A- 0 156 412  DE-A- 2 534 978
DE-A- 2 620 115  DE-A- 3 411 314
GB-A- 2 134 700  US-A- 3 968 455

(73) Proprietor: **N.V. Philips' Gloeilampenfabrieken
Groenewoudseweg 1
NL-5621 BA Eindhoven(NL)**

(72) Inventor: **Colak, Sel Brian
c/o INT. OCTROOIBUREAU B.V. Prof. Holst-
laan 6
NL-5656 AA Eindhoven(NL)**
Inventor: **Fitzpatrick, Brian John
c/o INT. OCTROOIBUREAU B.V. Prof. Holst-
laan 6
NL-5656 AA Eindhoven(NL)**

(74) Representative: **Houbiers, Ernest Emile Marie
Gerlach et al
INTERNATIONAAL OCTROOIBUREAU B.V.
Prof. Holstlaan 6
NL-5656 AA Eindhoven(NL)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The invention is related to an electron-beam pumped semiconductor laser having a substrate with an active region at a first major surface thereof, in which a longitudinal electron beam input to said first major surface of the laser causes a laser oscillation in said active region which results in a laser output at a second major surface opposite the first.

Moreover it is related to laser arrays provided with such electron-beam-pumped semi-conductor lasers.

Typically, prior electron-beam-pumped semiconductor lasers have used a longitudinal configuration, with laser amplification and oscillation in the same direction as the electron beam input and the laser output. Thus, laser amplification and oscillation occur in the direction of thickness (the " short" or longitudinal direction) in the laser body. Such a configuration has high threshold power due to inefficient pumping, which results in device heating and premature deterioration of the laser structure. Furthermore, the longitudinal configuration exhibits internal confinement problems. Nevertheless, this configuration has proven advantageous, particularly for display applications, because the output is normal to the major surface of the device, thus permitting the assembly of an array of such devices to form a flat display screen.

Electron-beam-pumped semiconductor layers have also been used in the transverse configuration, where the laser oscillation and amplification occur in a direction perpendicular to the electron beam input but parallel to the laser output. This configuration requires less input power density, due to the longer gain medium (amplification and oscillation occur parallel to the major surface of the device) and confinement is also better in this configuration. However, the drawback of the transverse configuration is that the laser output is now taken from the sides ofthe laser device, thus making this configuration of limited utility for large-area arrays or display screens.

Ideally, it would be desirable to have an electron-beam-pumped semiconductor laser device featuring the advantages of both the longitudinal and transverse prior-art configurations, while at the same time overcoming the drawbacks inherent in each of these configurations. Such a device would feature laser amplification and oscillation in the transverse direction (perpendicular to the electron beam) for improved longevity and confinement, while at the same time providing a longitudinal (parallel to the electron beam) laser output, to permit the device to be used advantageously in large-area laser arrays and display screens.

In such a device the advantages of both the longitudinal and transverse configurations are achieved, while the disadvantages of both configurations are avoided.

It is therefore an object of the present invention to provide an electron-beam-pumped semiconductor laser in which the laser amplification occurs substantially in a direction transverse to that of the electron beam direction, while the laser output is taken in a longitudinal direction from a major surface of the laser device.

It is a further object of the invention to provide an electron-beam-pumped semiconductor laser capable of operating at a relatively low threshold power to avoid damage to the laser device, while at the same time avoiding confinement problems.

Yet a further object of the invention is to provide an electron-beam-pumped semiconductor laser suitable for use in a large-area laser or array or display screen.

An electron-beam-pumped semiconductor laser according to the invention therefore is characterized in that said laser comprises

means comprising at least one pair of reflective grooves in the active region for generating a substantially transverse laser amplification in said active region resulting in a laser oscillation in response to said longitudinal electron beam input to said first major surface and

means for generating a longitudinal laser output from said laser oscillation in the same direction as that of the electron beam input at said second major surface.

The improvements of the invention are accomplished by generating a substantially transverse laser amplification in the active region, which results in a laser oscillation in response to the longitudinal electron beam input to the first major surface, while a longitudinal laser output is generated in the same direction as that of the electron beam input at the second major surface.

In a preferred embodiment of the invention, a pair of reflective vee-shaped approximately 45° grooves are provided in the active region to generate the substantially transverse laser amplification, and at least one partially-transmissive portion is provided in the second major surface located opposite one of the vee-shaped grooves to generate a longitudinal laser output.

Here it should be noted that in the substantially different field of luminescent screens, U.S. Patent No. 4,298,820 shows a luminescent screen in which closely-spaced grooves are provided to enhance the luminescent efficiency of the screen by optimizing its internal reflectivity.

In a further preferred embodiment, each pair of grooves includes one vee-shaped approximately 45° groove and one right-angle groove, with the longitudinal laser output being provided through a partially-transmissive portion of the second major surface located opposite the vee-shaped groove.

The electron-beam-pumped semiconductor laser structures described above may advantageously be used in an orthogonal grid array to form a transverse semiconductor laser structure, with the individual laser elements being separated by the pairs of grooves.

The configurations described above result in structures which feature the advantages of prior longitudinal structures (namely advantageous application in large-area displays) and prior transverse structures (namely lower operating power levels), while at the same time avoiding the disadvantages inherent in both of these prior-art configurations.

The invention will now be described more in detail with reference to the drawing in which

Figs. 1 and 2 are simplified cross-sectional views of prior-art semiconductor laser devices;

Fig. 3 is a cross-sectional view of an electron-beam-pumped semiconductor laser in accordance with a first embodiment of the invention;

Fig. 4 is a cross-sectional view of an electron-beam-pumped semiconductor laser in accordance with a second embodiment of the invention;

Fig. 5 is a cross-sectional view of an electron-beam-pumped semiconductor laser in accordance with a third embodiment of the invention; and

Fig. 6 is a plan view of an array of electron-beam-pumped semiconductors in accordance with the invention.

The drawings are shown in simplified schematic form in order to provide a technical background for understanding the invention.

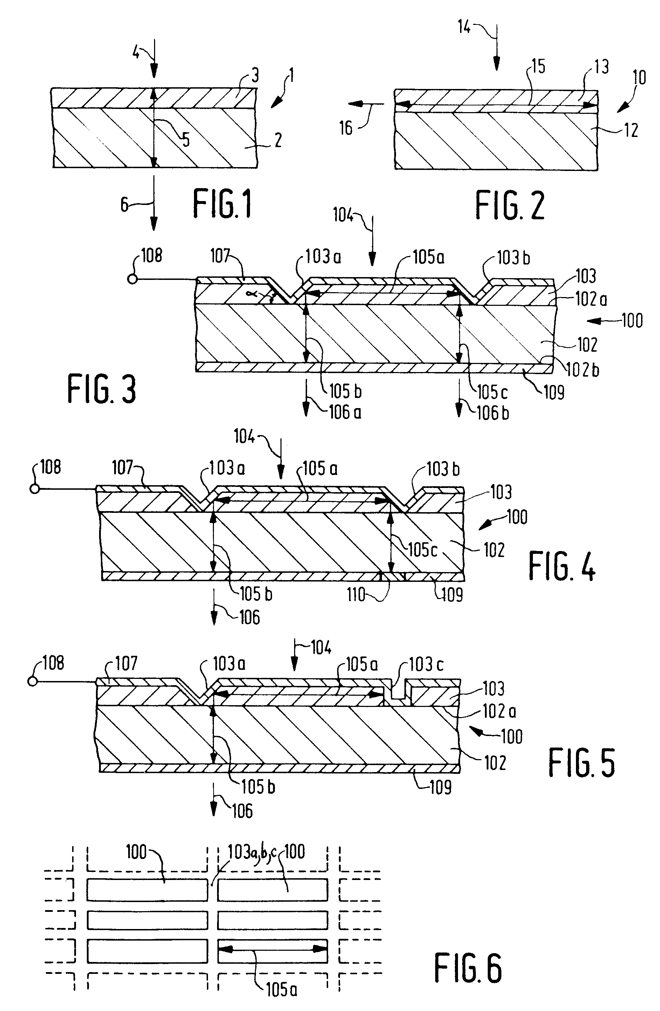

Figs. 1 and 2 show two typical constructions of prior-art electron-beam-pumped semiconductor lasers.

In Fig. 1, a semiconductor laser 1 having a longitudinal configuration includes a substrate 2 with an active region 3 at a first major surface. When an electron beam input is applied to the laser, as schematically shown by arrow 4, laser amplification and oscillation occur in the longitudinal (i.e. vertical) direction, as shown schematically by the bi-directional arrow 5. In this configuration, the laser output, shown schematically by arrow 6, is also in the longitudinal direction, so that the electron beam input, laser amplification and oscillation, and the laser output all occur in the same direction. As discussed above, this configuration has certain drawbacks, including high threshold power density and confinement problems. Nevertheless, because the longitudinal configuration provides an output from a major surface, in the same direction as the electron beam input, this configuration has previously been used for large-area laser array display screens. A scannable electron-beam pumped semiconductor laser having a longitudinal configuration is described in GB-A-2 134 700.

A second prior-art semiconductor laser structure is shown in Fig. 2. In this structure, a semiconductor laser device 10 includes a substrate 12 with an active region 13 at a major surface. In response to an electron beam input 14, laser amplification and oscillation (schematically shown by double-ended arrow 15) occur in the transverse direction, and laser output is taken in the transverse direction as shown schematically by arrow 16. As discussed above, the fact that the laser output has to be taken from the side of the semiconductor structure puts a limitation on making large-area laser array display screens using this transverse configuration. Nevertheless, since the laser amplification and oscillation occur over a larger region than in the longitudinal configuration of Fig. 1, the transverse-pumped configuration is less subject to damage from heat resulting from high power dissipation in a small area. An injection semiconductor laser diode having a transverse configuration is described in US-A-3968455.

Fig. 3 shows an electron-beam-pumped semiconductor laser in accordance with a first embodiment of the invention. This configuration provides the advantages of both of the above-described prior-art structures, while at the same time overcoming their disadvantages. In this embodiment, an electron-beam-pumped semiconductor laser 100 includes a substrate 102 with an active region 103 at a first major surface 102a. In accordance with the invention, the active region 103 is provided with a pair of reflective vee-shaped grooves 103a and 103b with the side walls of the grooves at an angle alpha of about 45° withrespect to the major surface 102a of the device. Within active layer 103 additional layered structures may be provided to help carrier collection and optical confinement.

As in the previous examples, this device is activated by a longitudinal electron beam input 104. In response to the electron beam input, laser amplification occurs in a substantially transverse direction in the active region 103, as shown by the bi-directional arrow 105a, in a similar manner to that shown for the transverse configuration of Fig. 2. However, because of the presence of the vee-shaped grooves 103a and 103b, the laser oscillation is not limited to the active region, but is also reflected at a 90° angle vertically downward. The oscillation path thus also includes sections 105b and 105c, which extend in a longitudinal direction down to major surface 102b at the lower portion of the device, as shown in Fig. 3. The output of the device is then taken from the lower major surface 102b, in the longitudinal direction, as shown schematically by arrows 106a and 106b. In this manner, the present invention affords a device configuration in which laser amplification is in a substantially transverse direction, for reduced heat generation and longer device life, while the laser output is taken in the longitudinal direction so that the device can advantageously be used in large-area laser array display screens.

The device shown in Fig. 3 is also provided with an upper electrode 107 having an electrode connection 108. The purpose of this electrode, which is substantially transparent to the electron beam input, serves to provide an electrical return to avoid charge accumulation in the laser device. Finally, the device includes a dielectric or metal coating 109 on the lower major surface 102b. In the example shown in Fig. 3, coating 109 is partly reflective beneath the V-shaped grooves 103 a and 103 b, so that the coating serves as both a reflective surface for the laser oscillation path 105-105b-105c and as an output surface for the laser output 106a, 106b.

It should be emphasized that the concept of the present invention may be advantageously employed in numerous different laser configurations, using various types of materials. $^F$or the device shown in Fig. 3, for example, the active region 103 may be of $CdS_xSe_{1-x}$ with a substrate of CdS. Other possible active region/substrate combinations are CdS on $Al_2O_3$ and ZnSe on $ZnS_xSe_{1-x}$. Electrode 107 may typically be of silver with a thickness of about 500 angstroms, while the lower coating 109 may be a silver coating of about 300 angstroms (1 angstrom = $10^{-10}$ m.) or else a conventional multilayer dielectric coating. A typical device might have a spacing between grooves 103a and 103b of between about 100-500 microns, with active region 103 having a thickness of between about 2-10 microns on a substrate 102 of about 300-1000 microns thickness.

A second embodiment of an electron-beam-pumped semiconductor laser in accordance with the invention is shown in Fig. 4. In most respects, this device is configured as described above, with like reference numerals being used to identify the corresponding parts of the device. The device of Fig. 4 differs from the previously-described device of Fig. 3 in that the lower coating 109 includes a portion 110 beneath groove 103b. This portion 110 is substantially completely reflective, in contrast to the partially-transmissive nature of coating 109 of Figs. 3 and 4. Because of the presence of coating portion 110, there is complete reflection of oscillation segment 105c and no laser output occurs beneath vee-shaped groove 103b. Thus, the entire laser output, shown schematically by the arrow labelled 106 in Fig. 4, occurs beneath vee-shaped groove 103a. The use of this configuration, with a single output path for each laser device, results in improved image definition when the invention is employed in a laser array. Coating portion 110 may be made completely reflective by any one of a number of well-known techniques. For example, if coating 109 is a partially-reflective silver layer having a thickness of about 300 angstroms, portion 110 can be made thicker, for example about 600 angstroms, to provide a substantially completely reflective region. Alternatively, if a multilayer dielectric coating is used, the thickness and/or number of layers may be adjusted in a known manner to achieve a substantially completely reflective surface for portion 110.

Fig. 5 shows a third embodiment of an electron-beam-pumped semiconductor laser in accordance with the invention. Again, many portions of the device shown in Fig. 5 are the same as the corresponding portions shown in Fig. 3, and like reference numerals are used to identify like parts. Fig. 5 differs from Figs. 3 and 4 in that laser amplification in the active region 103 occurs between a vee-shaped groove 103a as previously described and a second groove 103c which is a right-angle groove with side walls substantially perpendicular to major surface 102a. Because of the right-angle groove, the laser oscillation path 105a terminates at the groove side wall, and does not extend down into the semiconductor body beneath groove 103c. Beneath the vee-shaped groove 103a, the laser oscillation path is reflected downward, as shown by segment 105b, thus resulting in a single laser output 106 beneath the vee-shaped groove. Thus, this embodiment provides a single laser output beam as in Fig. 4, but avoids the necessity for having a substantially completely reflective portion 110 in the coating layer 109.

As mentioned above, devices in accordance with the present invention are particularly suitable for use in large-area laser arrays and display screens. In such applications, individual laser devices 100 as described above are arranged in an orthogonal grid-like array, as shown in Fig. 6, with the grooves 103 serving not only to define the desired laser oscillation path 105a, but also to separate and define the individual laser structures within the array, thus eliminating confinement losses. In this application, therefore, the grooved structures of the present invention are doubly advantageous.

## Claims

1.  An electron-beam-pumped semiconductor laser (100) having a substrate (102) with an active region (103) at a first major surface (102a) thereof, in which a longitudinal electron beam input (104) to said first major surface of the laser causes a laser oscillation in said active region which results in a laser output at a second major surface (102b) opposite the first, characterized in that said laser comprises

means comprising at least one pair of reflective grooves (103a,b) in the active region for generating a substantially transverse laser amplification (105a) in said active region resulting in a laser oscillation in response to said longitudinal electron beam input (104) to said first major surface and

means for generating a longitudinal laser output (106) from said laser oscillation in the same direction as that of the electron beam input (104) at said second major surface.

2. An electron-beam-pumped semiconductor laser according to Claim 1, characterized in that said means for generating a substantially transverse laser amplification (105a) comprises at least one pair of reflective vee-shaped grooves (103a,b) in said active region, and said means for generating a longitudinal laser output comprises at least one partially-transmissive portion (109) of said second major surface located opposite at least one of said pair of grooves.

3. An electron-beam-pumped semiconductor laser according to Claim 2, characterized in that said means for generating a longitudinal laser output (106) comprises only one partially-transmissive portion (109) of said second major surface for each pair of grooves.

4. An electron-beam-pumped semiconductor laser, according to Claim 1, characterized in that said means for generating a substantially transverse laser amplification (105a) comprises at least one pair of reflective grooves in said active region, a first of each pair of grooves comprising a vee-shaped groove (103a) and a second of each pair of grooves comprising a right-angle groove (103c), and said means for generating a longitudinal laser output comprises a partially-transmissive portion of said second major surface located opposite said vee-shaped groove.

5. A transverse semiconductor laser array (Fig.6) characterized in that said array comprises a plurality of electron-beam-pumped semiconductor lasers (100) according to Claim 2, said lasers being arranged in an orthogonal grid-like array and being separated by said vee-shaped grooves (103a,b).

6. A transverse semiconductor laser array (Fig.6) characterized in that said array comprises a plurality of electron-beam-pumped semiconductor lasers according to Claim 4, said lasers being arranged in an orthogonal gridlike array and being separated by said vee-shaped (103a) and right-angle (103c) grooves.

7. An electron-beam-pumped semiconductor laser according to Claim 2, characterized in that the spacing between said pair of vee-shaped grooves (103a,b) is between about 100-500 microns and the thickness of said active region (103) is between about 2-10 microns.

8. An electron-beam-pumped semiconductor laser according to Claim 7, characterized said active region (103) comprises $CdS_xSe_{1-x}$ and said substrate (102) comprises CdS.

9. An electron-beam-pumped semiconductor laser according to Claim 7, characterized in that said active region (103) comprises CdS and said substrate (102) comprises $Al_2O_3$.

10. An electron-beam-pumped semiconductor laser according to Claim 7, characterized in that said active region (103) comprises ZnSe and said substrate (102) comprises $ZnS_xSe_{1-x}$.

**Patentansprüche**

1. Elektronenstrahlgepumpter Halbleiterlaser (100) mit einem Substrat (102) mit einem aktiven Gebiet (103) an einer ersten Hauptfläche (102a) desselben, bei dem ein Längselektronenstrahleingang (104) zu der genannten ersten Hauptfläche des Lasers eine Laserschwingung in dem genannten aktiven Gebiet verursacht, was zu einem Laserausgag an der zweiten Hauptfläche (102b) gegenüber der ersten führt, dadurch gekennzeichnet, daß der genannte Laser die nachfolgenden Elemente aufweist:

- Mittel mit mindestens einem Paar reflektierender Rillen (103a,b) in dem aktiven Gebiet zum Erzeugen einer im wesentlichen queren Laserverstärkung (105a) in dem genannten aktiven Gebiet, was zu einer Laserschwingung in Antwort auf den genannten Längselektronenstrahleingang (104) zu der genannten ersten Hauptfläche führt, und

- Mittel zum Erzeugen eines Längslaserausgangs (106) aus der genannten Laserschwingung in derselben Richtung wie die des Elektronenstrahleingangs (104) an der genannten zweiten Hauptfläche.

2. Elektronenstrahlgepumpter Halbleiterlaser nach Anspruch 1, dadurch gekennzeichnet, daß die genannten Mittel zum Erzeugen einer im wesentlichen queren Laserverstärkung (105a) mindestens ein Paar reflektierender V-förmiger Pillen (103a,b) in dem genannten aktiven Gebiet aufweisen, und daß die Mittel zum Erzeugen eines Längslaserausgangs mindestens einen teilweise durchlässigen Teil (109) der genannten zweiten Hauptfläche gegenüber mindestens einer Rille des genannten Pillenpaares aufweisen.

3. Elektronenstrahlgepumpter Halbleiterlaser nach Anspruch 2, dadurch gekennzeichnet, daß die genannten Mittel zum Erzeugen eines Längslaserausgangs (106) nur einen teilweise durchlässigen Teil (109) der genannten Hauptfläche für jedes Rillenpaar aufweisen.

4. Elektronenstrahlgepumpter Halbleiterlaser nach Anspruch 1, dadurch gekennzeichnet, daß die genannten Mittel zum Erzeugen einer im wesentlichen queren Laserverstärkung (105a) mindestens ein Paar reflektierender Rillen in dem genannten Aktiven Gebiet aufweisen, wobei eine erste Rille (103a) jedes Rillenpaares V-förmig und eine zweite Rille (103c) jedes Rillenpaares rechteckig ist, und wobei die genannten Mittel zum Erzeugen eines Längslaserausgangs einen teilweise durchlässigen Teil der genannten zweiten Hauptfläche gegenüber der genannten V-förmigen Rille aufweisen.

5. Querhalbleiterlaseranordnung (Fig. 6), dadurch gekennzeichnet, daß diese Anordnung eine Anzahl elektronenstrahlgepumpter Halbleiterlaser (100) nach Anspruch 2 aufweist, wobei diese Laser in einer rechtwinkligen gitterartigen Konfiguration angeordnet und durch die genannten V-förmigen Rillen (103a,b) voneinander getrennt sind.

6. Querhalbleiterlaseranordnung (Fig. 6), dadurch gekennzeichnet, daß diese Anordnung eine Anzahl elektronenstrahlgepumpter Halbleiterlaser nach Anspruch 4 aufweist, wobei diese Laser in einer rechtwinkligen gitterartigen Konfiguration angeordnet und durch V-förmige und rechteckige Rillen (103a bzw. 103c) voneinander getrennt sind.

7. Elektronenstrahlgepumpter Halbleiterlaser nach Anspruch 2, dadurch gekennzeichnet, daß der Raum zwischen den V-förmigen Rillen des genannten Rillenpaares (103a,b) etwa 100 - 500 $\mu$m und die Dicke des genannten aktiven Gebietes (103) etwa 2 - 10 $\mu$m beträgt.

8. Elektronenstrahlgepumpter Halbleiterlaser nach Anspruch 7, dadurch gekennzeichnet, daß das genannte aktive Gebiet (103) $CdS_xSe_{1-x}$ und das genannte Substrat (102) CdS aufweist.

9. Elektronenstrahlgepumpter Halbleiterlaser nach Anspruch 7, dadurch gekennzeichnet, daß das genannte aktive Gebiet (103) CdS und das genannte Substrat (102) $Al_2O_3$ aufweist.

10. Elektronenstrahlgepumpter Halbleiterlaser nach Anspruch 7, dadurch gekennzeichnet, daß das genannte aktive Gebiet (103) ZnSe und das genannte Substrat (102) $ZnS_xSe_{1-x}$ aufweist.

**Revendications**

1. Laser semiconducteur à pompage par faisceau électronique (100) pourvu d'un substrat (102) présentant une région active (103) sur une première surface principale (102a) de celui-ci, un faisceau électronique (104) d'incidence longitudinale, frappant cette première surface principale du laser, ayant pour effet d'engendrer dans ladite région active une oscillation de laser provoquant une émission laser à l'endroit d'une seconde surface principale (102b), opposée à la première, caractérisé en ce qu'il comporte des moyens comportant au moins une paire de gorges réflectrices (103a, b) dans la région active pour engendrer dans cette région active une amplification laser sensiblement transversale (105a) provoquant une oscillation laser en réaction à l'incidence longitudinale dudit faisceau électronique (104) à ladite première surface principale et des moyens pour engendrer, à partir de ladite oscillation laser, une émission laser longitudinale (106) à l'endroit de ladite seconde surface principale, dans la même direction que l'incidence du faisceau électronique (104).

2. Laser semiconducteur à pompage par faisceau électronique selon la revendication 1, caractérisé en ce que lesdits moyens pour engendrer une amplification laser sensiblement transversale (105a) comportent au moins une paire de gorges réflectrices en V (103a) dans ladite région active et en ce que lesdits moyens pour engendrer une émission laser longitudinale comportent au moins une partie partiellement transmissive (109) de ladite seconde surface principale, située en face d'au moins l'une des gorges de ladite paire.

3. Laser semiconducteur à pompage par faisceau électronique selon la revendication 2, caractérisé en ce que lesdits moyens pour engendrer une émission laser longitudinale (106) ne comportent qu'une seule partie partiellement transmissive (109) de ladite seconde surface principale pour chaque paire de gorges.

4. Laser semiconducteur à pompage par faisceau électronique selon la revendication 1, caractérisé en ce que lesdits moyens pour engendrer une amplification laser sensiblement transversale (105a) comportent au moins une paire de gorges réflectrices dans ladite région active, une première de chaque paire de gorges comportant une gorge en V (103a) et une seconde de chaque paire de gorges comportant une gorge à angle droit (103c) et en ce que lesdits moyens pour engendrer une émission laser longitudinale comportent une partie partiellement transmissive de ladite seconde surface principale, située en face de ladite gorge en V.

5. Réseau laser semiconducteur transversal (figure 6), caractérisé en ce qu'il comporte une pluralité de lasers semiconducteurs par pompage par faisceau électronique (100) selon la revendication 2, lesdits lasers étant disposés dans un réseau orthogonal en forme de grille et étant séparés par lesdites gorges en V (103a, b).

6. Réseau laser semiconducteur transversal (figure 6), caractérisé en ce qu'il comporte une pluralité de lasers semiconducteurs à pompage par faisceau électronique selon la revendication 4, lesdits lasers étant disposés dans un réseau orthogonal en forme de grille et étant séparés par lesdites gorges en V (103a) et à angle droit (103c).

7. Laser semiconducteur à pompage par faisceau électronique selon la revendication 2, caractérisé en ce que l'écartement entre les gorges en V (103a, b) de ladite paire est compris entre 100 et 500 microns environ et en ce que l'épaisseur de ladite région active (103) est compris entre 2 et 10 microns environ.

8. Laser semiconducteur à pompage par faisceau électronique selon la revendication 7, caractérisé en ce que ladite région active (103) comporte du $CdS_xSe_{1-x}$ et en ce que ledit substrat (102) comporte du CdS.

9. Laser semiconducteur à pompage par faisceau électronique selon la revendication 7, caractérisé en ce que ladite région active (103) comporte du CdS et en ce que le substrat (102) comporte de l'$Al_2O_3$.

10. Laser semiconducteur à pompage par faisceau électronique selon la revendication 7, caractérisé en ce que ladite région active (103) comporte du ZnSe et en ce que ledit substrat (102) comporte du $SnS_xSe_{1-x}$.

EP 0 184 250 B1

FIG.1

FIG.2

FIG.3

FIG.4

FIG.5

FIG.6